# EUROPÄISCHE PATENTSCHRIFT

(11) **EP 3 117 457 B1**
(45) Veröffentlichungstag und Bekanntmachung des Hinweises auf die Patenterteilung: **19.08.2020**
(21) Anmeldenummer: 15706751.3
(22) Anmeldetag: 19.02.2015
(51) Int. Cl.: H01L 23/31, G01D 11/24, H01L 23/13, H01L 27/146, H01L 23/16

(54) **ELEKTRONISCHES MODUL SOWIE VERFAHREN ZUM HERSTELLEN EINES ELEKTRONISCHEN MODULS**
ELECTRONIC MODULE AND METHOD OF MANUFACTURING AN ELECTRONIC MODULE
MODULE ÉLECTRONIQUE AINSI QUE PROCÉDÉ DE FABRICATION D'UN MODULE ÉLECTRONIQUE

(30) Priorität: 14.03.2014 DE 102014204722
(43) Veröffentlichungstag der Anmeldung: 18.01.2017
(73) Patentinhaber: Robert Bosch GmbH, 70442 Stuttgart (DE)
(72) Erfinder: GEISLER, Dominik, 72074 Tübingen (DE); EHRENPFORDT, Ricardo, 70825 Korntal-Münchingen (DE); MOROSOW, Viktor, 72762 Reutlingen (DE); ANTE, Frederik, 70197 Stuttgart (DE)
(86) Internationale Anmeldenummer: PCT/EP2015/053458
(87) Internationale Veröffentlichungsnummer: WO 2015/135725

(56) Entgegenhaltungen:
- JP-A- 2004 028 952
- US-A- 5 817 535
- US-A1- 2004 188 838
- US-A1- 2005 097 941
- US-A1- 2005 189 635
- US-A1- 2010 230 792
- US-A1- 2012 090 381
- US-B1- 6 617 695

## Beschreibung

### Stand der Technik

Die vorliegende Erfindung bezieht sich auf ein elektronisches Modul und auf ein Verfahren zum Herstellen eines elektronischen Moduls. Sensorelemente können zum Schutz vor Umwelteinflüssen von einem Gehäuse umgeben sein. Ein solches Gehäuse kann beispielsweise in einem Spritzgussverfahren hergestellt werden.

Die Druckschrift US 2004/188838 A1 offenbart eine Halbleitereinheit zur Fingerabdruckerkennung.

Die Druckschrift US 6 617 695 B1 offenbart eine Halbleitereinheit und ein Halbleitermodul, das die Halbleitereinheit verwendet.

Die Druckschrift US 2005/189635 A1 offenbart einen gepackten akustischen und elektromagnetischen Transducer-Chip.

Die Druckschrift US 5 817 535 A offenbart ein einzelzeiliges Speichermodul mit einem Vorsprung über den Chip.

Die Druckschrift US 2010/230792 A1 offenbart vorgeformte Substrate mit Öffnungen für Halbleiterwürfel-Verbünde mit einem gestapelten Halbleiterwürfel.

Die Druckschrift US 2012/090381 A1 offenbart einen Gassensor.

Die Druckschrift US 2005/097941 A1 offenbart eine Gassensorbaugruppe.

Die Druckschrift JP 2004 028952 A offenbart einen Gasdetektor.

Offenbarung der Erfindung

Ver diesem Hintergrund werden mit dem hier vorgestellten Ansatz ein elektronisches Modul gemäß Anspruch 1 und ein Verfahren zum Herstellen eines solchen Moduls gemäß Anspruch 5 vorgestellt.

Vorteilhafte Ausgestaltungen ergeben sich aus den jeweiligen Unteransprüchen und der nachfolgenden Beschreibung.

Es wird ein elektronisches Modul mit folgenden Merkmalen vorgestellt: zumindest einer Trägerplatte, wobei eine Kontaktierungsseite der Trägerplatte zumindest ein Kontaktelement aufweist; und zumindest einem elektronischen Bauelement, das auf der Kontaktierungsseite angeordnet ist, wobei das Kontaktelement das elektronische Bauelement überragt.

Unter einer Trägerplatte kann ein Substrat zum Aufnehmen eines elektronischen Bauelements verstanden werden. Beispielsweise kann es sich bei der Trägerplatte um eine Platte mit metallischen Leiterbahnen handeln. Unter einem Kontaktelement kann ein Element verstanden werden, das ausgebildet ist, um die Trägerplatte beispielsweise mit einer weiteren Platte elektrisch und/oder mechanisch zu verbinden. Das Kontaktelement kann etwa als Lotkugel realisiert sein.

Der vorliegende Ansatz beruht auf der Erkenntnis, dass ein Trägersubstrat eines elektronischen Moduls zur Abdeckung eines elektronischen Bauelements verwendet werden kann. Das Trägersubstrat kann ferner ein Kontaktelement aufweisen, das das elektronische Bauelement überragt. Dadurch kann das elektronische Modul in einem Schritt elektrisch kontaktiert und fixiert werden. Indem beispielsweise ein Sensorchip derart durch einen Funktionsträger geschützt wird, kann ein kostengünstiges Sensorgehäuse mit ein- oder beidseitigem Medienzugang und der Möglichkeit einer Chipstapelung bereitgestellt werden.

Auf der Grundlage eines derart vereinfachten Verpackungskonzepts können unterschiedliche Anforderungen bezüglich eines Partikel- und Lichteinflusses sehr flexibel realisiert werden, wie etwa Chips mit abgedeckten sensitiven Bereichen oder EMV-Schutz (EMV = elektromagnetische Verträglichkeit). Für Gassensoren können beispielsweise spezielle AVT-Konzepte (AVT = Aufbau- und Verbindungstechnik) in Form einer Stapelung von Infrarotquellen und Infrarotdetektoren vorgesehen sein. Somit kann eine Bauform eines elektronischen Moduls möglichst kompakt gehalten werden.

Indem statt eines Metalldeckels und einer Moldmasse ein Trägersubstrat und beispielsweise Lotballs zur Abdeckung verwendet werden, können die Kosten der Aufbau- und Verbindungstechnik reduziert werden.

Durch den Wegfall eines Moldschritts kann eine AVT-Belastung verringert werden.

Ferner ermöglicht der vorliegende Ansatz die Realisierung einer abgedeckten sensitiven Struktur mittels Hinterschnitt.

Optional kann ein Sealring zum Schutz vor Lotspritzern und Flussmitteldämpfen verwendet werden.

Durch den Wegfall von Drahtbonds kann ein lateraler Platzbedarf verringert werden.

Dadurch, dass das Trägersubstrat als Abdeckung selbst Funktionsträger bzw.

Umverdrahtungsträger ist, wird eine einfache Stapelung zweier Halbleiterbauelemente ermöglicht, die beispielsweise durch Strahlung in Wechselwirkung stehen.

Die Trägerplatte weist zumindest eine Durchgangsöffnung auf. Hierbei ist die Durchgangsöffnung dem elektronischen Bauelement gegenüberliegend angeordnet und als ein fluidischer Kanal zwischen der Kontaktierungsseite und einer der Kontaktierungsseite gegenüberliegenden Seite der Trägerplatte ausgebildet. Mittels der Durchgangsöffnung kann mit einfachen und kostengünstigen Mitteln ein Medienzugang zu dem elektronischen Bauelement realisiert werden.

Das elektronische Modul kann mit zumindest einem Verbindungselement vorgesehen sein, das das elektronische Bauelement elektrisch leitfähig mit der Trägerplatte verbindet. Hierbei kann das Verbindungselement zwischen dem elektronischen Bauelement und der Trägerplatte angeordnet sein, um zumindest im Bereich der Durchgangsöffnung einen Zwischenraum zwischen dem elektronischen Bauelement und der Trägerplatte zu bilden. Alternativ oder zusätzlich kann die Trägerplatte zumindest teilweise aus einem Kunststoff gefertigt sein. Unter einem Verbindungselement kann ein Abstandhalter verstanden werden. Das Verbindungselement kann als elektrischer Anschlusskontakt, etwa in Form einer Lotkugel, realisiert sein. Bei der Trägerplatte kann es sich um eine Leiterplatte aus Kunststoff handeln. Beispielsweise kann die Leiterplatte aus einem Duroplast, insbesondere einem Duroplast mit eingelassenen Glasfasern, gefertigt sein. Dadurch kann die Trägerplatte besonders kosteneffizient bereitgestellt werden. Mittels des Zwischenraums können verschiedene physikalische Eigenschaften einer Außenumgebung des elektronischen Moduls erfasst werden. Beispielsweise kann das elektronische Bauelement hierzu einen sensitiven Bereich aufweisen.

Ferner weist das elektronische Bauelement einen sensitiven Bereich zum Erfassen zumindest einer physikalischen Eigenschaft der Außenumgebung des elektronischen Moduls auf, wobei der sensitive Bereich der Kontaktierungsseite gegenüberliegend angeordnet ist. Unter einem sensitiven Bereich wird ein Bereich eines Sensorelements verstanden, der ausgebildet ist, um bestimmte physikalische Eigenschaften wie etwa Druck, Temperatur, Feuchte, bestimmte Gase oder Helligkeit der Außenumgebung zu erfassen. Der sensitive Bereich kann über die Durchgangsöffnung fluidisch mit der Außenumgebung verbunden sein. Somit lässt sich eine Sensorfunktion des elektronischen Moduls mit geringem Kosten- und Herstellungsaufwand realisieren. In einem Beispiel, das nicht Teil der vorliegenden Erfindung ist, kann alternativ oder zusätzlich der sensitive Bereich der Durchgangsöffnung gegenüberliegend angeordnet sein. Dadurch kann ein Abstand zwischen der Außenumgebung des elektronischen Moduls und dem sensitiven Bereich möglichst gering gehalten werden und eine hohe Genauigkeit bei der Erfassung der physikalischen Eigenschaften der Außenumgebung sichergestellt werden. Beispielsweise kann somit erreicht werden, dass durch die Durchgangsöffnung fallendes Licht direkt auf den sensitiven Bereich trifft.

Gemäß einer weiteren Ausführungsform des vorliegenden Ansatzes kann die Kontaktierungsseite eine aktive Struktur zum Beeinflussen zumindest einer physikalischen Eigenschaft einer Außenumgebung des sensitiven Bereichs aufweisen. Hierbei kann die aktive Struktur dem sensitiven Bereich gegenüberliegend angeordnet sein. Unter einer aktiven Struktur kann beispielsweise eine auf den sensitiven Bereich gerichtete Strahlungsquelle, etwa in Form einer Heizstruktur oder einer Infrarotquelle, oder eine Membran verstanden werden. Bei der aktiven Struktur kann es sich auch um eine weitere sensitive Struktur, d. h. einen weiteren Sensor, handeln. Mittels der aktiven Struktur kann eine Effizienz der Sensorfunktion des elektronischen Moduls verbessert werden.

Gemäß einem weiteren Beispiel, das nicht Teil der vorliegenden Erfindung ist, kann das elektronische Modul mit zumindest einem weiteren elektronischen Bauelement vorgesehen sein, das auf einer der Kontaktierungsseite gegenüberliegenden Seite der Trägerplatte der Durchgangsöffnung gegenüberliegend angeordnet ist und elektrisch leitfähig mit der Trägerplatte verbunden ist. Somit können mehrere elektronische Bauelemente platzsparend miteinander kombiniert werden.

Eine besonders kompakte Bauform des elektronischen Moduls lässt sich realisieren, wenn gemäß einer weiteren Ausführungsform des vorliegenden Ansatzes eine Haupterstreckungsachse der Trägerplatte und eine Haupterstreckungsachse des elektronischen Bauelements in unterschiedliche Richtungen weisen. Unter einer Haupterstreckungsachse kann eine Achse einer größten Ausdehnung der Trägerplatte bzw. des elektronischen Bauelements verstanden werden. Beispielsweise kann eine Längsachse der Trägerplatte quer zu einer Längsachse des elektronischen Bauelements angeordnet sein.

Der vorliegende Ansatz schafft zudem ein Verfahren zum Herstellen eines elektronischen Moduls gemäß Anspruch 5.

Der hier vorgestellte Ansatz wird nachstehend anhand der beigefügten Zeichnungen beispielhaft näher erläutert. Es zeigen:
Fig. 1 eine schematische Darstellung eines elektronischen Moduls gemäß einem Beispiel, das nicht Teil der vorliegenden Erfindung ist;
Fig. 2a, 2b schematische Darstellungen eines elektronischen Moduls gemäß einem Beispiel, das nicht Teil der vorliegenden Erfindung ist;
Fig. 3a, 3b schematische Darstellungen eines elektronischen Moduls gemäß einem Ausführungsbeispiel der vorliegenden Erfindung;
Fig. 4a, 4b schematische Darstellungen eines elektronischen Moduls gemäß einem Beispiel, das nicht Teil der vorliegenden Erfindung ist;
Fig. 5a, 5b schematische Darstellungen eines elektronischen Moduls gemäß einem Beispiel, das nicht Teil der vorliegenden Erfindung ist;
Fig. 6 eine schematische Darstellung eines elektronischen Moduls gemäß einem Beispiel, das nicht Teil der vorliegenden Erfindung ist;
Fig. 7 eine schematische Darstellung eines elektronischen Moduls gemäß einem Ausführungsbeispiel der vorliegenden Erfindung;
Fig. 8 eine schematische Darstellung eines elektronischen Moduls gemäß einem Beispiel, das nicht Teil der vorliegenden Erfindung ist;
Fig. 9 eine schematische Darstellung eines elektronischen Moduls gemäß einem Beispiel, das nicht Teil der vorliegenden Erfindung ist;
Fig. 10 eine schematische Darstellung eines elektronischen Moduls gemäß einem Beispiel, das nicht Teil der vorliegenden Erfindung ist;
Fig. 11a, 11b, 11c schematische Darstellungen eines herkömmlichen elektronischen Moduls;
Fig. 12a, 12b schematische Darstellungen eines herkömmlichen elektronischen Moduls;
Fig. 13 eine schematische Darstellung eines herkömmlichen elektronischen Moduls;
Fig. 14 eine schematische Darstellung einer Spritzgussvorrichtung zur Herstellung eines herkömmlichen elektronischen Moduls;
Fig. 15 ein Ablaufdiagramm eines Verfahrens zum Herstellen eines elektronischen Moduls gemäß einem Beispiel, das nicht Teil der vorliegenden Erfindung ist; und
Fig. 16 ein Blockschaltbild einer Vorrichtung zum Durchführen eines Verfahrens gemäß einem Beispiel, das nicht Teil der vorliegenden Erfindung ist.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

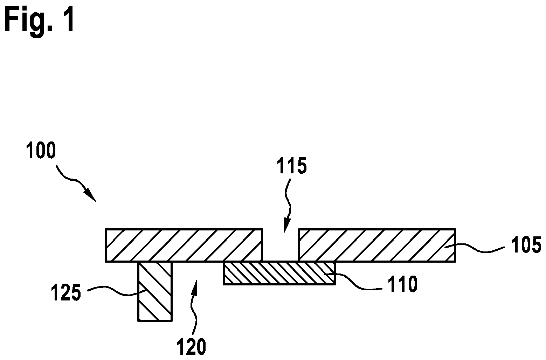

Fig. 1 zeigt eine schematische Darstellung eines elektronischen Moduls 100 gemäß einem Beispiel, das nicht Teil der vorliegenden Erfindung ist. Das elektronische Modul 100 umfasst eine Trägerplatte 105 und ein elektronisches Bauelement 110. Die Trägerplatte 105 ist mit einer Durchgangsöffnung 115 ausgeführt. Das elektronische Bauelement 110 ist auf einer Kontaktierungsseite 120 der Trägerplatte 105 gegenüber der Durchgangsöffnung 115 angeordnet. Hierbei kann das elektronische Bauelement 110 elektrisch leitfähig mit der Trägerplatte 105 verbunden sein. Auf der Kontaktierungsseite 120 ist ferner ein Kontaktelement 125 angeordnet. Das Kontaktelement 125 ragt über das elektronische Bauelement 110 hinaus.

Die Durchgangsöffnung 115 ist ausgebildet, um eine fluidische Verbindung zwischen einer der Durchgangsöffnung 115 zugewandten Oberfläche des elektronischen Bauelements 110 und einer der Kontaktierungsseite 120 gegenüberliegenden Seite der Trägerplatte 105 herzustellen.

Das Kontaktelement 125 dient der mechanischen Befestigung des elektronischen Moduls 100. Zusätzlich kann das Kontaktelement 125 ausgebildet sein, um die Trägerplatte 105 elektrisch zu kontaktieren.

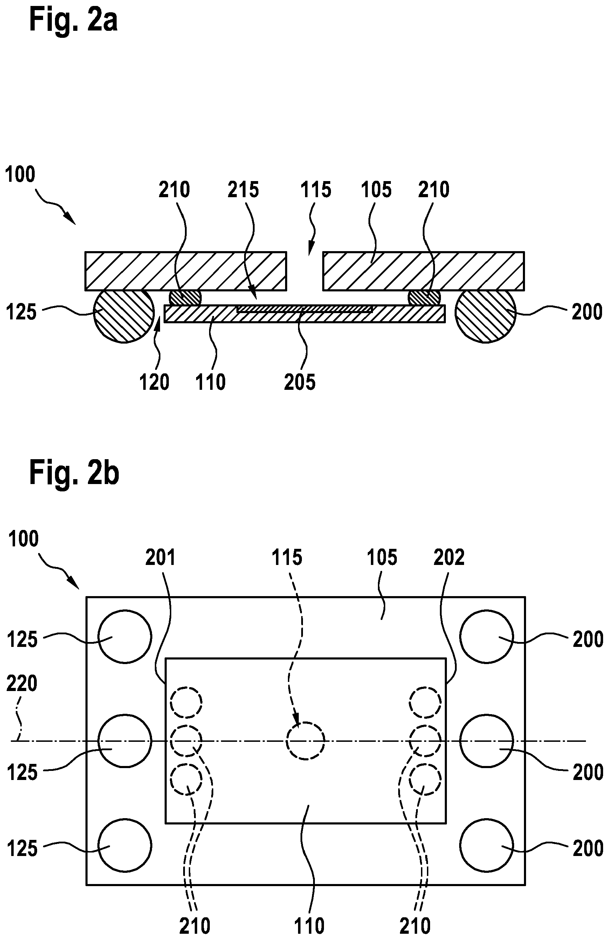

Die Figuren 2a und 2b zeigen schematische Darstellungen eines elektronischen Moduls 100 gemäß einem Beispiel, das nicht Teil der vorliegenden Erfindung ist. Fig.

2a zeigt eine Seitenansicht des elektronischen Moduls 100; Fig. 2b zeigt eine Draufsicht auf das elektronische Modul 100. Im Gegensatz zu Fig. 1 ist das in den Figuren 2a und 2b gezeigte elektronische Modul 100 beispielhaft mit drei Kontaktelementen 125 sowie drei weiteren Kontaktelementen 200 realisiert. Die Kontaktelemente 125 und die weiteren Kontaktelemente 200 sind hierbei je in Dreierreihen angeordnet. Die drei weiteren Kontaktelemente 200 sind wie die Kontaktelemente 125 auf der Kontaktierungsseite 120 angeordnet und ragen über das elektronische Bauelement 110 hinaus.

Wie in Fig. 2b zu sehen, sind die Kontaktelemente 125 benachbart zu einer ersten Kante 201 des elektronischen Bauelements 110 und die weiteren Kontaktelemente 200 benachbart zu einer der ersten Kante 201 gegenüberliegenden zweiten Kante 202 des elektronischen Bauelements 110 angeordnet. Die Kontaktelemente 125, 200 sind beispielsweise als Lotkugeln realisiert.

Eine der Kontaktierungsseite 120 zugewandte Oberfläche des elektronischen Bauelements 110 umfasst einen sensitiven Bereich 205, der ausgebildet ist, um bestimmte physikalische Eigenschaften einer Außenumgebung des elektronischen Moduls 100 zu erfassen. Der sensitive Bereich 205 ist der Durchgangsöffnung 115 gegenüberliegend angeordnet.

Zwischen dem elektronischen Bauelement 110 und der Trägerplatte 105 sind beispielhaft sechs Verbindungselemente 210 in zwei Dreierreihen angeordnet. Beispielhaft erstreckt sich eine erste Dreierreihe der Verbindungselemente 210 parallel zu einer Dreierreihe der Kontaktelemente 125 und eine zweite Dreierreihe der Verbindungselemente 210 parallel zu einer Dreierreihe der weiteren Kontaktelemente 200. Die Verbindungselemente 210 sind ausgebildet, um das elektronische Bauelement 110 an der Trägerplatte 105 zu befestigen und elektrisch leitfähig mit der Trägerplatte 105 zu verbinden. Durch die Verbindungselemente 210 ist das elektronische Bauelement 110 in einem im Wesentlichen einer Höhe der Verbindungselemente 210 entsprechenden Abstand zur Trägerplatte 105 angeordnet. Somit ergibt sich zwischen dem elektronischen Bauelement 110 und der Trägerplatte 105 ein Zwischenraum 215, der über die Durchgangsöffnung 115 mit der der Kontaktierungsseite 120 gegenüberliegenden Seite der Trägerplatte 105 fluidisch verbunden ist.

Die Verbindungselemente 210 können wie die Kontaktelemente 125, 200 als Lotkugeln realisiert sein.

Wie in Fig. 2b gezeigt, sind die Trägerplatte 105 und das elektronische Bauelement 110 je rechteckig ausgeführt. Beispielhaft erstrecken sich die Trägerplatte 105 und das elektronische Bauelement 110 entlang einer gemeinsamen Längsachse 220. Hierbei sind die jeweiligen Dreierreihen der Kontaktelemente 125, der weiteren Kontaktelemente 200 sowie der Verbindungselemente 210 quer zur Längsachse 220 angeordnet.

Ein Sensorsystem 100 ist mit einem Leiterplatten-Trägersubstrat 105 vorgesehen, das einen Medienzugang 115 aufweist. Ein Sensorchip 110 ist mittels sechs Lötballs als Verbindungselemente 210 an einer Unterseite des Trägersubstrats 105 befestigt. Das Trägersubstrat 105 weist Lötballs als Kontaktelemente 125, 200 zur Kontaktierung einer weiteren Platine auf. Die Lötballs 125, 200 überragen den Sensorchip 110 in vertikaler Richtung. Der Medienzugang 115 ist lateral über einem sensitiven Bereich 205 des Sensorchips 110 orientiert. Zusätzlich ergibt sich ein seitlicher Medienzugang zwischen Trägersubstrat 105 und Sensorchip 110. Bei dem seitlichen Medienzugang handelt es sich beispielsweise um einen Bereich zwischen den Lotkugeln 210.

Die Leiterplatte 105 kann metallische Leiterbahnen zur Umverdrahtung, metallische Durchkontakte und Padflächen umfassen. Der Medienzugang 115 im Trägersubstrat 105 kann beispielsweise durch Bohren, Fräsen oder Lasern hergestellt werden. Hierbei kann der Medienzugang 115 mit einem runden Querschnitt ausgeführt sein.

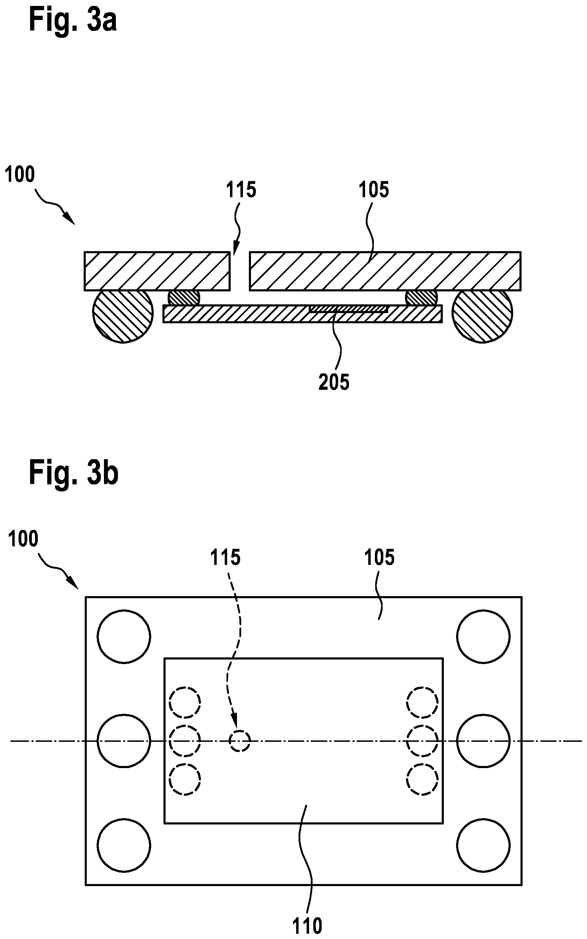

Die Figuren 3a und 3b zeigen schematische Darstellungen eines elektronischen Moduls 100 gemäß einem Ausführungsbeispiel der vorliegenden Erfindung. Im Unterschied zu Fig. 2a ist die Durchgangsöffnung 115 in Fig. 3a versetzt zu dem sensitiven Bereich 205 angeordnet, sodass der sensitive Bereich 205 vollständig von der Trägerplatte 105 abgedeckt ist. Ferner ist die Durchgangsöffnung 115 beispielhaft mit einem deutlich geringeren Durchmesser als in den Figuren 2a und 2b ausgeführt.

Ein Sensorsystem 100 mit einem seitlich zur sensitiven Struktur 205 des Sensorchips 110 versetzten Medienzugang 115 bietet beispielsweise den Vorteil eines verbesserten Partikel- oder Lichtschutzes.

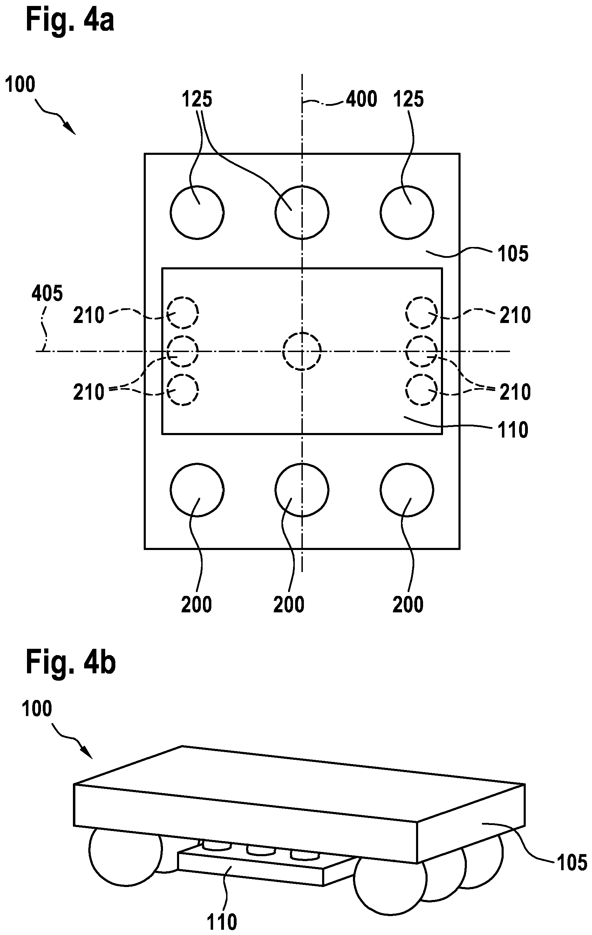

Die Figuren 4a und 4b zeigen schematische Darstellungen eines elektronischen Moduls 100 gemäß einem Beispiel, das nicht Teil der vorliegenden Erfindung ist. In Fig. 4a ist eine Draufsicht auf das elektronische Modul 100 dargestellt; Fig. 4b zeigt eine schematische dreidimensionale Darstellung des elektronischen Moduls 100. Im Unterschied zu den Figuren 2a und 2b erstrecken sich die Trägerplatte 105 und das elektronische Bauelement 110 in den Figuren 4a und 4b entlang unterschiedlicher Längsachsen. Beispielhaft ist eine Längsachse 400 der Trägerplatte 105 im Wesentlichen rechtwinklig zu einer Längsachse 405 des elektronischen Bauelements 110 angeordnet. Somit sind auch die jeweiligen Dreierreihen der Kontaktelemente 125 und der weiteren Kontaktelemente 200 im Wesentlichen rechtwinklig zu den jeweiligen Dreierreihen der Verbindungselemente 210 angeordnet.

Ein Trägersubstrat 105 und mindestens ein Halbleiterchip 110 bilden eines Sensorsystems 100 zwei um 90 Grad verdrehte Rechtecke, d. h., eine kurze Kante des Halbleiterchips 110 verläuft parallel zu einer langen Kante des Trägersubstrats 105. Hierbei sind die Kontaktelemente 210 des mindestens einen Halbleiterchips 110 und die Kontaktelemente 125, 200 des Trägersubstrats 105 je als mindestens zwei Reihen zu den jeweiligen beiden kurzen Kanten eines Rechtecks hin orientiert.

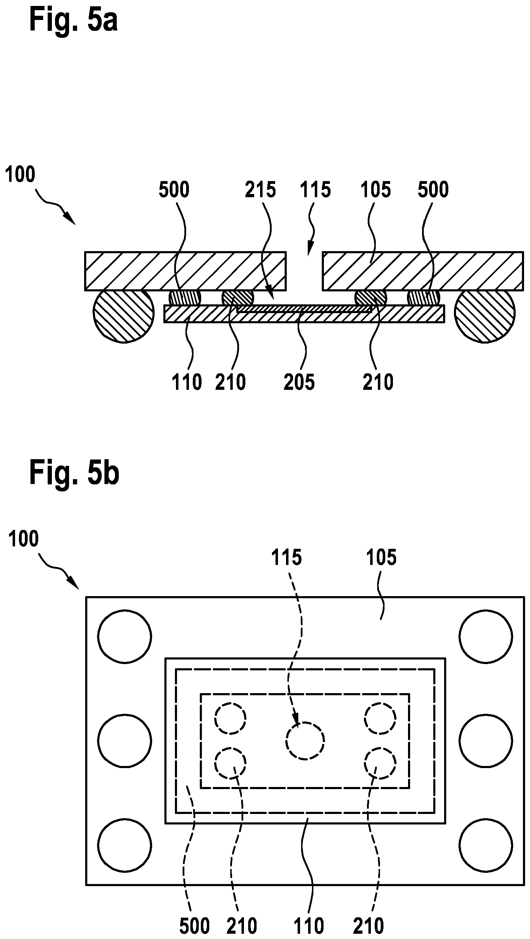

Die Figuren 5a und 5b zeigen schematische Darstellungen eines elektronischen Moduls 100 gemäß einem nicht zur Erfindung gehörenden Ausführungsbeispiel. Im Gegensatz zu dem in den Figuren 2a und 2b gezeigten elektronischen Modul 100 weist das elektronische Modul 100 in den Figuren 5a und 5b einen Dichtrand 500 auf. Der Dichtrand 500 ist zwischen dem elektronischen Bauelement 110 und der Trägerplatte 105 entlang eines äußeren Randbereichs des elektronischen Bauelements 110 angeordnet. Der Dichtrand 500 ist ausgebildet, um einen Randbereich des Zwischenraums 215 zu begrenzen und fluiddicht zu verschließen. Hierbei sind die Verbindungselemente 210 innerhalb des von dem Dichtrand 500 begrenzten Zwischenraums 215 angeordnet.

In den Figuren 5a und 5b sind beispielhaft nur vier statt sechs Verbindungselemente 210 dargestellt. Hierbei sind die Verbindungselemente 210 in zwei Zweierreihen angeordnet.

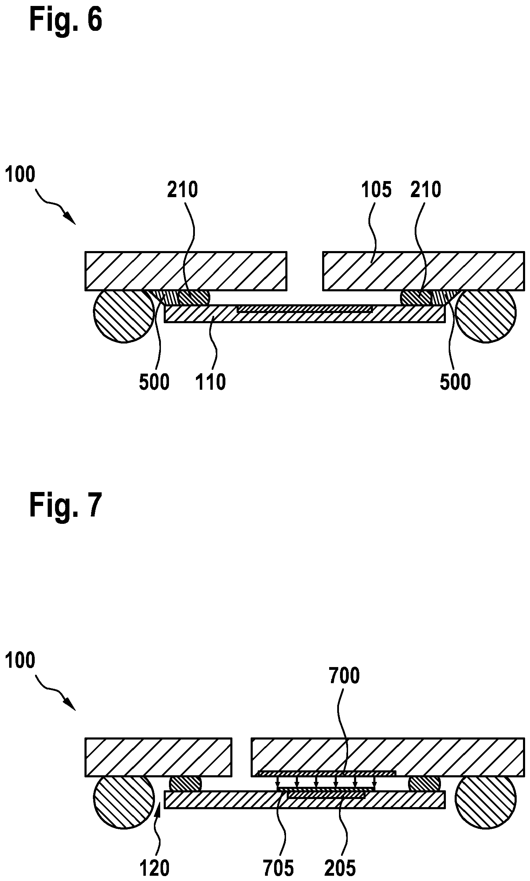

Gemäß einem nicht zur Erfindung gehörenden Ausführungsbeispiel ist das mindestens eine elektronische Halbleiterbauelement 110 mit einem Dichtrand 500 in Form eines Befestigungsrings an dem Trägersubstrat 105 befestigt, wobei der Befestigungsring 500 den Zwischenraum 215 zwischen Halbleiterbauelement 110 und Trägersubstrat 105 lateral eingrenzt und abdichtet. Bei dem Befestigungsring 500 kann es sich etwa um einen Sealring aus Lot oder Kupfer oder um einen Kleber, beispielsweise einen Underfiller oder Sidefiller, handeln, wie in Fig. 6 gezeigt.

Fig. 6 zeigt eine schematische Darstellung eines elektronischen Moduls 100 gemäß einem Beispiel, das nicht Teil der vorliegenden Erfindung ist. In Fig. 6 ist der Dichtrand 500 im Unterschied zu den Figuren 5a und 5b durch eine zwischen der Trägerplatte 105 und dem elektronischen Bauelement 110 eingebrachte Klebemasse realisiert.

Fig. 7 zeigt eine schematische Darstellung eines elektronischen Moduls 100 gemäß einem Ausführungsbeispiel der vorliegenden Erfindung. Im Gegensatz zu den Figuren 3a und 3b umfasst die in Fig. 7 gezeigte Kontaktierungsseite 120 eine aktive Struktur 700, wobei ein Hauptanteil der aktiven Struktur 700 dem sensitiven Bereich 205 gegenüberliegend angeordnet ist. Die aktive Struktur 700 ist beispielsweise ausgebildet, um den sensitiven Bereich 205 zu erwärmen.

Gemäß einem Ausführungsbeispiel der vorliegenden Erfindung ist in einem oberflächennahen Bereich des Trägersubstrats 105 orientiert zur sensitiven und/oder aktiven Struktur 205 des mindestens einen Halbleiterbauelements 110 eine weitere sensitive und/oder aktive Struktur 700 ausgebildet, beispielsweise eine integrierte Strahlungsquelle in Form einer Infrarotquelle oder Heizstruktur. Ferner kann der Chip 110 zusätzlich zu dem sensitiven Material 205 einen Detektor 705, etwa einen Infrarotdetektor, umfassen.

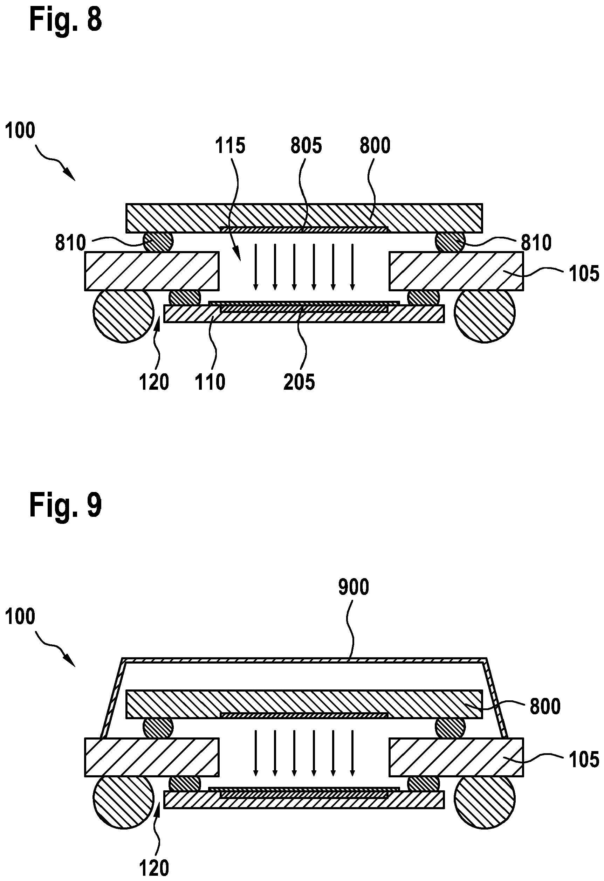

Fig. 8 zeigt eine schematische Darstellung eines elektronischen Moduls 100 gemäß einem Beispiel, das nicht Teil der vorliegenden Erfindung ist. Im Unterschied zu den Figuren 2a und 2b ist die in Fig. 8 gezeigte Durchgangsöffnung 115 mit einem Durchmesser ausgeführt, der im Wesentlichen einer Breite des sensitiven Bereichs 205 entspricht. Das elektronische Modul 100 umfasst zudem ein weiteres elektronisches Bauelement 800, das auf einer der Kontaktierungsseite 120 gegenüberliegenden Seite der Trägerplatte 105 befestigt ist. Beispielsweise ist das weitere elektronische Bauelement 800 mittels Lotkugeln auf die Trägerplatte 105 aufgelötet.

Das weitere elektronische Bauelement 800 umfasst einen aktiven Bereich 805, der der Durchgangsöffnung 115 und somit dem sensitiven Bereich 205 des elektronischen Bauelements 110 gegenüberliegend angeordnet ist. Hierbei ist der aktive Bereich 805 beispielhaft mit einer Breite realisiert, die im Wesentlichen dem Durchmesser der Durchgangsöffnung 115 entspricht.

Der aktive Bereich 805 kann ähnlich der in Fig. 7 gezeigten aktiven Struktur 700 ausgebildet sein, um den sensitiven Bereich 205 zu bestrahlen.

Gemäß einem Beispiel, das nicht Teil der vorliegenden Erfindung ist, ist mindestens ein weiteres elektronisches Halbleiterbauelement 800 mit mindestens einem weiteren Kontaktelement 810 auf einer Oberseite eines Kunststoffträgersubstrats 105 angebracht. Das mindestens eine weitere elektronische Bauelement 800 weist eine oberflächennahe sensitive und/oder aktive Struktur 805 auf, die sich an einer zum Kunststoff-Trägersubstrat 105 orientierten Seite des Halbleiterbauelements 800 befindet.

Hierbei ist ein fluidisches Durchloch 115 im Trägersubstrat 105 von seinen lateralen Abmessungen derart ausgeführt, dass sich die sensitiven und/oder aktiven Strukturen 205, 805 der beiden Halbleiterbauelemente 110, 800 unabgedeckt gegenüberliegen.

Beispielsweise ist ein Chip 800 als UV-Diode oder Infrarotquelle realisiert, um als Strahlungsquelle zu fungieren.

Fig. 9 zeigt eine schematische Darstellung eines elektronischen Moduls 100 gemäß einem Beispiel, das nicht Teil der vorliegenden Erfindung ist. Im Unterschied zu dem in Fig. 8 gezeigten elektronischen Modul 100 umfasst das in Fig. 9 gezeigte elektronische Modul 100 ein Deckelelement 900, das auf der der Kontaktierungsseite 120 gegenüberliegenden Seite der Trägerplatte 105 befestigt ist und das weitere elektronische Bauelement 800 überspannt, um das weitere elektronische Bauelement 805 vor Umwelteinflüssen zu schützen. Das Deckelelement 900 kann auch als Deckel oder Abdeckung bezeichnet werden.

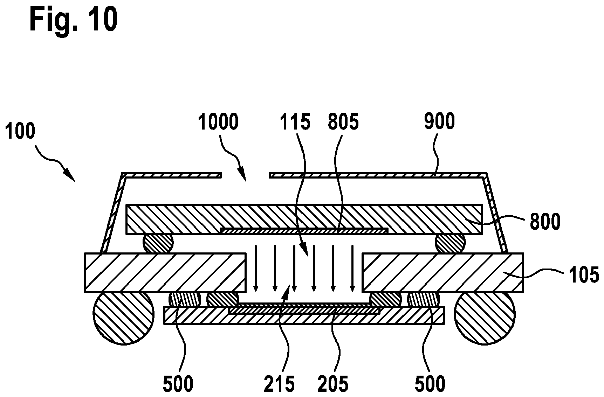

Fig. 10 zeigt eine schematische Darstellung eines elektronischen Moduls 100 gemäß einem Beispiel, das nicht Teil der vorliegenden Erfindung ist. Im Gegensatz zu

Fig. 9 weist das in Fig. 10 gezeigte Deckelelement 900 eine Deckelöffnung 1000 als Medienzugang auf. Ferner weist das in Fig. 10 gezeigte Modul 100 den anhand der Figuren 5a und 5b beschriebenen Dichtrand 500 auf. Der sensitive Bereich 205 und der aktive Bereich 805 sind zudem geringfügig breiter als die Durchgangsöffnung 115 ausgeführt.

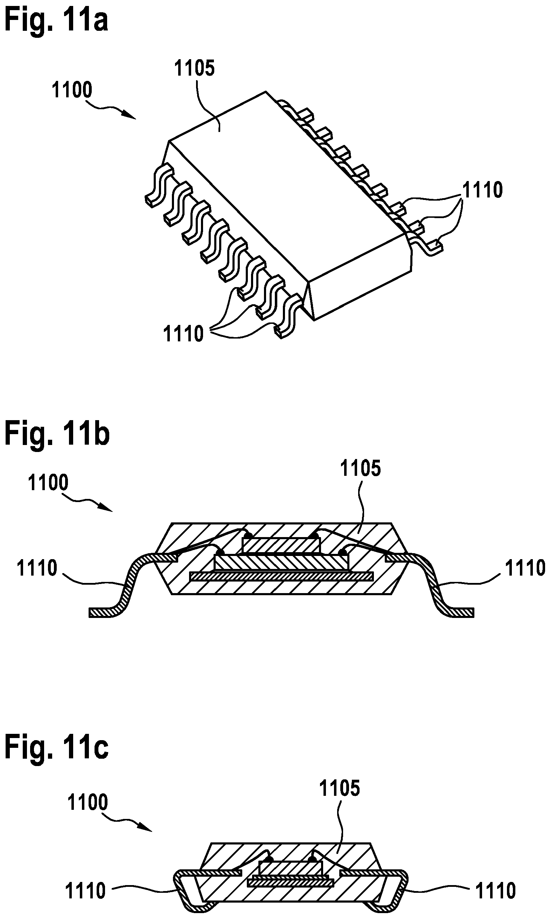

Die Figuren 11a bis 11c zeigen schematische Darstellungen eines herkömmlichen elektronischen Moduls 1100. In Fig. 11a ist eine schematische dreidimensionale Darstellung des Moduls 1100 gezeigt. Das Modul 1100 ist mit einem Vollgussgehäuse 1105 realisiert. Das Vollgussgehäuse 1105 kann auch als SOIC-Full-Moldgehäuse bezeichnet werden (SOIC = small outline integrated circuit; "integrierter Schaltkreis mit kleinem Grundriss"). Zwei einander gegenüberliegende Seiten des Vollgussgehäuses 1105 weisen je eine Mehrzahl s-förmig gebogener Kontaktdrähte 1110 auf, auch Leads genannt, die der elektrischen Kontaktierung des Moduls 1100 dienen.

Wie in Fig. 11b dargestellt, umfasst das mit dem Vollgussgehäuse 1105 umgossene Modul 1100 einen Plattenstapel aus einem ersten Siliziumchip 1115, einem zweiten Siliziumchip 1120 und einem Substrat 1125, auch Diepad genannt. Die Siliziumchips 1115, 1120 sind mittels Golddrähten mit den Kontaktdrähten 1110 elektrisch leitfähig verbunden.

In Fig. 11c sind die Kontaktdrähte 1110 J-förmig umgebogen, englisch auch j-formed leadframe genannt. Die Kontaktdrähte 1110 sind beispielsweise aus Kupfer gefertigt.

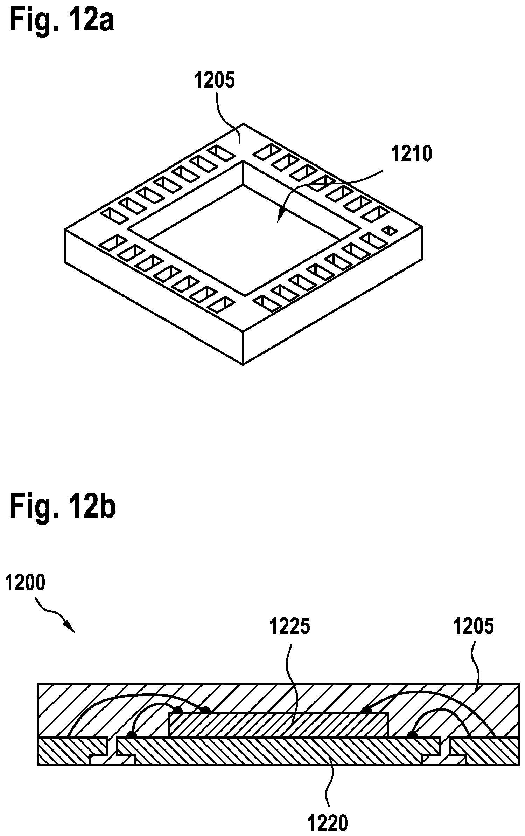

Die Figuren 12a und 12b zeigen schematische Darstellungen eines herkömmlichen elektronischen Moduls 1200. Das Modul 1200 umfasst ein kontaktloses Spritzgussgehäuse 1205, das in Fig. 12a gesondert dargestellt ist. Das Spritzgussgehäuse 1205 kann auch als leadless-Moldgehäuse bezeichnet werden. Das Spritzgussgehäuse 1205 weist eine rechteckige zentrale Öffnung 1210 auf. Um die Öffnung 1210 herum ist eine Mehrzahl rechteckiger Kontaktierungsöffnungen 1215 angeordnet.

Wie in Fig. 12b gezeigt, umfasst das elektronische Modul 1200 ein Kupferblech 1220, auf dem ein Siliziumchip 1225 befestigt ist. Das Kupferblech 1220 kann auch als Leadframe bezeichnet werden. Der Siliziumchip 1225 ist mittels Golddrähten elektrisch leitfähig mit dem Kupferblech 1220 verbunden. Der Siliziumchip 1225 ist mit dem Spritzgussgehäuse 1205 umgossen.

Mikromechanische Sensoren werden üblicherweise in Moldgehäusen verpackt. Dabei kann zwischen sogenannten leaded-Gehäusen, die gebogene Kontaktfüße für eine Second-level-Kontaktierung aufweisen und komplett ummoldet sein können, und übermoldeten sogenannten leadless-Gehäusen ohne Kontaktbeinchen unterschieden werden. Die Second-level-Kontaktierung kann hierbei über Kontaktflächen an einer Packageunterseite realisiert sein.

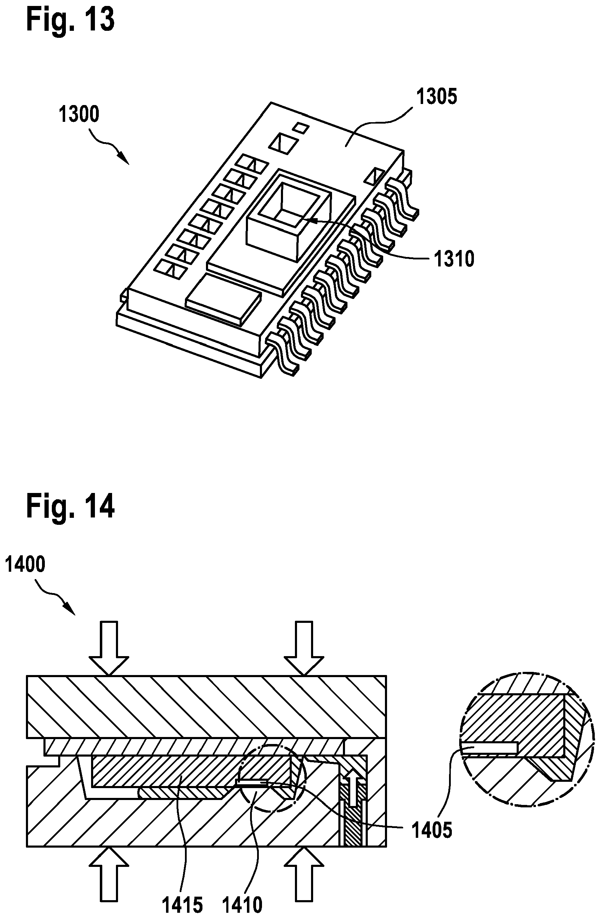

Fig. 13 zeigt eine schematische Darstellung eines herkömmlichen elektronischen Moduls 1300. Das Modul 1300 ist in ein sogenanntes Premold-Gehäuse 1305 integriert. Dabei handelt es sich um ein vorgefertigtes, spritzgegossenes Grundgehäuse, das nach dem Setzen und Kontaktieren eines Siliziumchips mit einem Deckel verschlossen werden kann. Das Premold-Gehäuse 1305 stellt eine stressarme Packageform dar, da kein direkter Kontakt zwischen den Verbundpartnern Silizium und Vergussmasse besteht.

Eine Kavität innerhalb des Packages 1300 kann über eine als Medienzugang fungierende Packageöffnung 1310, beispielsweise im Deckel, mit einer Außenumgebung verbunden sein. Der Medienzugang kann beispielsweise für Drucksensoren, Infrarotsensoren, Gassensoren und Mikrofone verwendet werden. Solche Medienzugänge können auch in Gehäusen mit spritzgepresster Kapselung von Bauteilen, auch Fullmold-Packages genannt, realisiert sein, wie vorangehend anhand der Figuren 11a bis 11c beschrieben.

Fig. 14 zeigt eine schematische Darstellung einer Spritzgussvorrichtung 1400 zur Herstellung eines herkömmlichen elektronischen Moduls 1405. Ein Verfahren zur Realisierung dieser Packageform beruht auf dem sogenannten Filmmoldverfahren, englisch film assisted molding (FAM). Dabei wird ein Medienzugang 1405 über die Form eines Moldwerkzeugs realisiert. Eine hervorstehende Werkzeugstruktur 1410 setzt hierbei direkt auf einem Siliziumchip 1415 auf und verhindert beispielsweise das Übermolden einer Drucksensor-Membran. Zum Toleranzausgleich kann das Moldwerkzeug mit einem ETFE-Film überzogen sein (ETFE = Ethylen-Tetrafluorethylen). Dieser ist stark deformierbar und legt sich formtreu über eine Werkzeugoberfläche. Bei diesem Verfahren besteht eine direkte Abhängigkeit zwischen Sensorlayout und Werkzeugstrukturen. Das Werkzeug sollte die aktiven Membranstrukturen abdecken, ohne Padflächen oder Drahtbonds zu verhüllen. Somit sind bestimmte Designregeln einzuhalten.

Des Weiteren kann je nach Layout auch ein vollflächiges Aufsetzen des Werkzeugs 1410 auf aktiven Strukturen wie Membranen erforderlich sein, was zu starken mechanischen Belastungen führen kann. Zudem sind mit diesem Verfahren Hinterschnitte bei Kavitäten kaum zu realisieren.

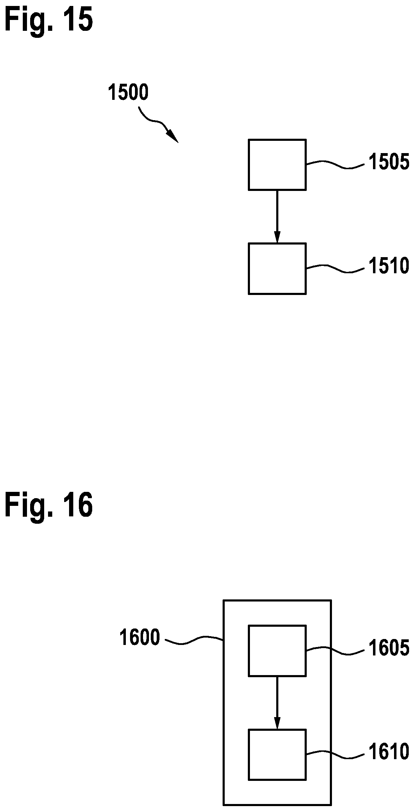

Fig. 15 zeigt ein Ablaufdiagramm eines Verfahrens 1500 zum Herstellen eines elektronischen Moduls gemäß einem einem Beispiel, das nicht Teil der vorliegenden Erfindung ist. Das Verfahren 1500 umfasst einen Schritt 1505 des Bereitstellens zumindest einer Trägerplatte mit zumindest einer Durchgangsöffnung, wobei eine Kontaktierungsseite der Trägerplatte zumindest ein Kontaktelement aufweist, sowie zumindest eines elektronischen Bauelements. Des Weiteren umfasst das Verfahren 1500 einen Schritt 1510 des Bildens eines Verbunds aus der Trägerplatte und dem elektronischen Bauelement. Hierbei wird das elektronische Bauelement auf der Kontaktierungsseite der Durchgangsöffnung gegenüberliegend angeordnet, wobei das Kontaktelement das elektronische Bauelement überragt.

Fig. 16 zeigt ein Blockschaltbild einer Vorrichtung 1600 zum Durchführen eines Verfahrens gemäß einem Beispiel, das nicht Teil der vorliegenden Erfindung ist. Die Vorrichtung 1600 umfasst eine Einheit 1605, die ausgebildet ist, um zumindest eine Trägerplatte mit zumindest einer Durchgangsöffnung sowie zumindest ein elektronisches Bauelement bereitzustellen, wobei eine Kontaktierungsseite der Trägerplatte zumindest ein Kontaktelement aufweist. Ferner umfasst die Vorrichtung 1600 eine Einheit 1610, die ausgebildet ist, um einen Verbund aus der Trägerplatte und dem elektronischen Bauelement zu bilden. Hierbei wird das elektronische Bauelement auf der Kontaktierungsseite der Durchgangsöffnung gegenüberliegend angeordnet, wobei das Kontaktelement das elektronische Bauelement überragt.

Gemäß einem in den vorangehend beschriebenen Figuren gezeigten Ausführungsbeispiel umfasst ein Sensor 100 bzw. ein Sensorgehäuse 100 und ein Verfahren zur Herstellung des Sensors 100 ein Kunststoff-Trägersubstrat 105, mindestens ein elektronisches Halbleiterbauelement 110, mindestens ein erstes metallisches Kontaktelement 210 sowie mindestens ein zweites metallisches Kontaktelement 125.

Hierbei ist das mindestens eine elektronische Halbleiterbauelement 110 mit dem mindestens einen ersten metallischen Kontaktelement 210 sowie das mindestens eine zweite metallische Kontaktelement 125 an einer Unterseite des KunststoffTrägersubstrats 105 angebracht, wobei das mindestens eine zweite metallische Kontaktelement 125 das mindestens eine elektronische Halbleiterbauelement 110 vertikal überragt.

Beispielsweise handelt es sich bei dem Kunststoff-Trägersubstrat 105 um eine duroplastische Leiterplatte, auch Printed Circuit Board (PCB) genannt, mit Glasfaserverstärkung, metallischen Leiterbahnen, metallischen Padflächen und metallischen Durchkontakten. Das Trägersubstrat 105 ist somit als ein duroplastischer Schaltungs- bzw. Umverdrahtungsträger realisiert.

Das elektronische Halbleiterbauelement 110 weist eine oberflächennahe sensitive und/oder aktive Struktur 205 auf, die sich an einer zum duroplastischen Trägersubstrat 105 orientierten Oberseite des Halbleiterbauelements 110 befindet.

Das duroplastische Trägersubstrat 105 weist ein fluidisches Durchloch 115 auf, das lateral gesehen versetzt bezüglich der sensitiven und/oder aktiven Struktur 205 angeordnet ist.

Ferner kann das fluidische Durchloch 115 hinsichtlich seiner lateralen Abmessungen deutlich kleiner als die sensitive und/oder aktive Struktur 205 ausgeführt sein.

Die Kontaktelemente 125, 210 können als Lotkugeln, Lotbumps, Cu-Pillars oder Goldstuds ausgeführt sein.

Als sensitive, oberflächennahe Strukturen 205, 700, 805 können beispielsweise Membranen, Heizstrukturen, strahlungsemittierende Strukturen, polymere Schichten, Diodenstrukturen, Transistorstrukturen, metallische Schichten, Interdigitalstrukturen oder entsprechende Kombinationen verwendet werden.

Die beschriebenen und in den Figuren gezeigten Ausführungsbeispiele sind nur beispielhaft gewählt. Unterschiedliche Ausführungsbeispiele können miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Elektronisches Modul (100) mit folgenden Merkmalen:
zumindest einer Trägerplatte (105), wobei eine Kontaktierungsseite (120) der Trägerplatte (105) zumindest ein Kontaktelement (125) aufweist; und
zumindest einem elektronischen Bauelement (110), das auf der Kontaktierungsseite (120) angeordnet ist, wobei das Kontaktelement (125) das elektronische Bauelement (110) überragt,
wobei die Trägerplatte (105) zumindest eine Durchgangsöffnung (115) aufweist, wobei die Durchgangsöffnung (115) dem elektronischen Bauelement (110) gegenüberliegend angeordnet ist und als ein fluidischer Kanal zwischen der Kontaktierungsseite (120) und einer der Kontaktierungsseite (120) gegenüberliegenden Seite der Trägerplatte (105) ausgebildet ist,
wobei das elektronische Bauelement (110) einen sensitiven Bereich (205) zum Erfassen zumindest einer physikalischen Eigenschaft einer Außenumgebung des elektronischen Moduls (100) aufweist, wobei der sensitive Bereich (205) der Kontaktierungsseite (120) gegenüberliegt,
**dadurch gekennzeichnet, dass**
die Durchgangsöffnung (115) versetzt zu dem sensitiven Bereich (205) angeordnet ist und wobei der sensitive Bereich (205) vollständig von der Trägerplatte (105) abgedeckt ist.

2. Elektronisches Modul (100) nach Anspruch 1, **gekennzeichnet durch** zumindest ein Verbindungselement (210), das das elektronische Bauelement (110) elektrisch leitfähig mit der Trägerplatte (105) verbindet, wobei das Verbindungselement (210) zwischen dem elektronischen Bauelement (110) und der Trägerplatte (105) angeordnet ist, um zumindest im Bereich der Durchgangsöffnung (115) einen Zwischenraum (215) zwischen dem elektronischen Bauelement (110) und der Trägerplatte (105) zu bilden, und/oder wobei die Trägerplatte (105) zumindest teilweise aus einem Kunststoff gefertigt ist.

3. Elektronisches Modul (100) gemäß einem der vorangegangenen Ansprüche, **dadurch gekennzeichnet, dass** die Kontaktierungsseite (120) eine aktive Struktur (700) zum Beeinflussen zumindest einer physikalischen Eigenschaft einer Außenumgebung des sensitiven Bereichs (205) aufweist, wobei die aktive Struktur (700) dem sensitiven Bereich (205) gegenüberliegend angeordnet ist.

4. Elektronisches Modul (100) gemäß einem der vorangegangenen Ansprüche, **dadurch gekennzeichnet, dass** eine Haupterstreckungsachse (400) der Trägerplatte (105) und eine Haupterstreckungsachse (405) des elektronischen Bauelements (110) in unterschiedliche Richtungen weisen.

5. Verfahren (1500) zum Herstellen eines elektronischen Moduls (100) gemäß einem der vorangegangenen Ansprüche, wobei das Verfahren (1500) folgende Schritte umfasst:
Bereitstellen (1505) zumindest einer Trägerplatte (105), wobei eine Kontaktierungsseite (120) der Trägerplatte (105) zumindest ein Kontaktelement (125) aufweist, sowie zumindest eines elektronischen Bauelements (110), wobei die Trägerplatte (105) zumindest eine Durchgangsöffnung (115) aufweist, wobei die Durchgangsöffnung (115) dem elektronischen Bauelement (110) gegenüberliegend angeordnet ist, und das elektronische Bauelement (110) einen sensitiven Bereich (205) zum Erfassen zumindest einer physikalischen Eigenschaft einer Außenumgebung des elektronischen Moduls (100) aufweist; und
Bilden (1510) eines Verbunds aus der Trägerplatte (105) und dem elektronischen Bauelement (110), wobei das elektronische Bauelement (110) auf der Kontaktierungsseite (120) angeordnet wird, wobei das
Kontaktelement (125) das elektronische Bauelement (110) überragt, wobei
im Schritt des Bildens (1510) die Öffnung derart mit der Trägerplatte verbunden wird, dass sie als ein fluidischer Kanal zwischen der Kontaktierungsseite (120) und einer Kontaktierungsseite (120) gegenüberliegenden Seite der Trägerplatte (105) ausgebildet ist, und
dass der sensitive Bereich (205) der Kontaktierungsseite (120) gegenüberliegend und die Durchgangsöffnung (115) versetzt zu dem sensitiven Bereich (205) angeordnet wird, und wobei der sensitive Bereich (205) vollständig von der Trägerplatte (105) abgedeckt wird.

## Claims

1. Electronic module (100) having the following features:
at least one support plate (105), wherein a contact-making side (120) of the support plate (105) has at least one contact element (125); and
at least one electronic component (110) which is arranged on the contact-making side (120), wherein the contact element (125) projects beyond the electronic component (110),
wherein the support plate (105) has at least one passage opening (115), wherein the passage opening (115) is arranged opposite the electronic component (110) and is in the form of a fluidic channel between the contact-making side (120) and a side of the support plate (105) which is situated opposite the contact-making side (120),
wherein the electronic component (110) has a sensitive region (205) for detecting at least one physical property of an external environment of the electronic module (100), wherein the sensitive region (205) is situated opposite the contact-making side (120),
**characterized in that**
the passage opening (115) is arranged offset in relation to the sensitive region (205), and wherein the sensitive region (205) is completely covered by the support plate (105) .

2. Electronic module (100) according to Claim 1, **characterized by** at least one connecting element (210) which electrically conductively connects the electronic component (110) to the support plate (105), wherein the connecting element (210) is arranged between the electronic component (110) and the support plate (105) in order to form, at least in the region of the passage opening (115), an intermediate space (215) between the electronic component (110) and the support plate (105), and/or wherein the support plate (105) is at least partially produced from a plastic.

3. Electronic module (100) according to either of the preceding claims, **characterized in that** the contact-making side (120) has an active structure (700) for influencing at least one physical property of an external environment of the sensitive region (205), wherein the active structure (700) is arranged opposite the sensitive region (205).

4. Electronic module (100) according to one of the preceding claims, **characterized in that** an axis (400) of main extent of the support plate (105) and an axis (405) of main extent of the electronic component (110) point in different directions.

5. Method (1500) for producing an electronic module (100) according to one of the preceding claims, wherein the method (1500) comprises the following steps:
providing (1505) at least one support plate (105), wherein a contact-making side (120) of the support plate (105) has at least one contact element (125), and also at least one electronic component (110), wherein the support plate (105) has at least one passage opening (115), wherein the passage opening (115) is arranged opposite the electronic component (110), and the electronic component (110) has a sensitive region (205) for detecting at least one physical property of an external environment of the electronic module (100); and forming (1510) a composite from the support plate (105) and the electronic component (110), wherein the electronic component (110) is arranged on the contact-making side (120), wherein the contact element (125) projects beyond the electronic component (110), wherein, in the forming step (1510), the opening is connected to the support plate in such a way that it forms a fluidic channel between the contact-making side (120) and a side of the support plate (105) which is situated opposite the contact-making side (120), and the sensitive region (205) is arranged opposite the contact-making side (120) and the passage opening (115) is arranged offset in relation to the sensitive region (205), and wherein the sensitive region (205) is completely covered by the support plate (105) .

## Revendications

1. Module électronique (100) ayant les caractéristiques suivantes :
au moins une plaque porteuse (105), un côté d'établissement de contact (120) de la plaque porteuse (105) possédant au moins un élément de contact (125) ; et
au moins un composant électronique (110) qui est disposé sur le côté d'établissement de contact (120), l'élément de contact (125) faisant saillie du composant électronique (110),
la plaque porteuse (105) possédant au moins une ouverture de passage (115), l'ouverture de passage (115) étant disposée à l'opposé du composant électronique (110) et étant réalisée sous la forme d'un canal fluidique entre le côté d'établissement de contact (120) et un côté de la plaque porteuse (105) à l'opposé du côté d'établissement de contact (120),
le composant électronique (110) possédant une zone sensible (205) destinée à détecter au moins une propriété physique d'un environnement extérieur du module électronique (100), la zone sensible (205) se trouvant à l'opposé du côté d'établissement de contact (120),
**caractérisé en ce que**
l'ouverture de passage (115) est disposée décalée par rapport à la zone sensible (205) et la zone sensible (205) étant entièrement recouverte par la plaque porteuse (105) .

2. Module électronique (100) selon la revendication 1, **caractérisé par** au moins un élément de liaison (210) qui relie de manière électriquement conductrice le composant électronique (110) à la plaque porteuse (105), l'élément de liaison (210) étant disposé entre le composant électronique (110) et la plaque porteuse (105) afin de former, au moins dans la zone de l'ouverture de passage (115), un espace intermédiaire (215) entre le composant électronique (110) et la plaque porteuse (105) et/ou la plaque porteuse (105) étant au moins partiellement fabriquée en matière plastique.

3. Module électronique (100) selon l'une des revendications précédentes, **caractérisé en ce que** le côté d'établissement de contact (120) possède une structure active (700) destinée à influencer au moins une propriété physique d'un environnement extérieur de la zone sensible (205), la structure active (700) étant disposée à l'opposé de la zone sensible (205).

4. Module électronique (100) selon l'une des revendications précédentes, **caractérisé en ce qu'**un axe de projection principal (400) de la plaque porteuse (105) et un axe de projection principal (405) du composant électronique (110) sont orientés dans des directions différentes.

5. Procédé (1500) de fabrication d'un module électronique (100) selon l'une des revendications précédentes, le procédé (1500) comprenant les étapes suivantes :
fourniture (1505) d'au moins une plaque porteuse (105), un côté d'établissement de contact (120) de la plaque porteuse (105) possédant au moins un élément de contact (125), ainsi qu'au moins un composant électronique (110), la plaque porteuse (105) possédant au moins une ouverture de passage (115), l'ouverture de passage (115) étant disposée à l'opposé du composant électronique (110) et le composant électronique (110) possédant une zone sensible (205) destinée à détecter au moins une propriété physique d'un environnement extérieur du module électronique (100) ; et
formation (1510) d'un composite constitué de la plaque porteuse (105) et du composant électronique (110), le composant électronique (110) étant disposé sur le côté d'établissement de contact (120), l'élément de contact (125) faisant saillie du composant électronique (110),
à l'étape de formation (1510), l'ouverture étant reliée à la plaque porteuse de telle sorte qu'elle réalisée sous la forme d'un canal fluidique entre le côté d'établissement de contact (120) et un côté de la plaque porteuse (105) à l'opposé du côté d'établissement de contact (120) et la zone sensible (205) se trouvant à l'opposé du côté d'établissement de contact (120) et l'ouverture de passage (115) étant disposée décalée par rapport à la zone sensible (205) et la zone sensible (205) étant entièrement recouverte par la plaque porteuse (105).
